# EUROPÄISCHE PATENTSCHRIFT

(11) **EP 0 763 895 B1**
(45) Veröffentlichungstag und Bekanntmachung des Hinweises auf die Patenterteilung: **12.11.2003**
(21) Anmeldenummer: 96113004.4
(22) Anmeldetag: 13.08.1996
(51) Int. Cl.: H03K 17/082

(54) **Schaltungsanordnung und Halbleiterkörper mit einem Leistungsschalter**
Circuit arrangement and semiconductor body with a power switch
Montage et corps semi-conducteur avec un commutateur de puissance

(30) Priorität: 14.09.1995 DE 19534160
(43) Veröffentlichungstag der Anmeldung: 19.03.1997
(73) Patentinhaber: Infineon Technologies AG, 81669 München (DE)
(72) Erfinder: Jenö, Tihanyi, Dr. Ing., 85551 Kirchheim (DE)
(74) Vertreter: Patentanwälte Westphal, Mussgnug & Partner

(56) Entgegenhaltungen:
- EP-A- 0 118 336
- EP-A- 0 397 015
- EP-A- 0 595 018
- EP-A- 0 629 001
- DE-A- 2 752 742
- US-A- 4 814 288
- US-A- 4 896 245
- H. SAX ET. AL.: "SMART POWER VERLUSTARME STEUERUNGS-TREIBER" ELEKTRONIK, Bd. 40, Nr. 2, 1. April 1991, Seiten 152-156, XP000225181 MUNCHEN,DE

## Beschreibung

Die Erfindung bezieht sich auf eine Schaltungsanordnung mit einem zwischen einer ersten Klemme und einer zweiten Klemme liegenden Leistungsschalter und mit einer dazu parallel liegenden Temperatursensorschaltung, die mit einem zwischen einen Steueranschluß des Leistungsschalters und die zweite Klemme geschalteten elektronischen Schalter zum Ausschalten des Leistungsschalters bei Übertemperatur verbunden ist, sowie auf einen Halbleiterkörper für eine solche Schaltungsanordnung.

Eine solche Schaltungsanordnung ist beispielsweise in EP 0 208 970 B1 beschrieben. Zum Schutz des Leistungs-MOS-FET bei auftretender Übertemperatur ist auf einen den Leistungs-MOS-FET enthaltenden Halbleiterkörper ein zweiter Halbleiterkörper geklebt, welcher eine Temperatursensorschaltung und einen Halbleiterschalter enthalt. Die beiden Halbleiterkörper stehen einander in gutem Wärmekontakt, so daß eine auftretende Übertemperatur innerhalb des Halbleiterkörpers des Leistungs-MOS-FET in der Temperatursensorschaltung erfaßt werden kann. Der elektronische Schalter, z. B. ein Thyristor, innerhalb des zweiten Halbleiterkörpers ist zwischen die Sourceelektrode und Drainelektrode des Leistungs-MOS-FET geschaltet. Steigt die Temperatur im Inneren des MOS-FET durch Überlastung oder hohe Umgebungstemperatur an, schließt der im zweiten Halbleiterkörper enthaltende, elektronische Schalter die Gateelektrode zur Sourceelektrode des MOS-FET kurz, so daß die im eingeschalteten Zustand zuvor zwischen Sourceelektrode und Gateelektrode des MOS-FET anstehende Spannung zusammenbricht und der MOS-FET ausschaltet.

Problematisch bei dieser Lösung ist die Verwendung von zwei übereinander zu montierenden Chips, nämlich einen den Schalttransistor enthaltenden Chip und einen darauf geklebten Temperatursensorchip. Diese Lösung ist verhältnismäßig umständlich, da eine doppelte Chipmontage notwendig und eine äußere Beschaltung erforderlich ist, um eine ausreichende Kurzschlußfestigkeit der gesamten Anordnung zu gewährleisten.

Selbst wenn der Temperatursensor in den Halbleiterkörper des Leistungs-MOS-FET integriert würde, wäre ein sicheres Abschalten des Leistungs-MOS-FET nicht immer gewährleistet. Es hat sich nämlich herausgestellt, daß die bekannten Temperatursensoranordnungen nur dann den Leistungs-MOS-FET sicher ausschalten, wenn ein ausreichend großer Spannungsabfall an der Temperatursensorschaltung und damit zwischen der Drain-Source-Strecke des Leistungs-MOS-FET gegeben ist. Die Temperatursensorschaltung schaltet zwar bei einer Chiptemperatur von etwa 150° C bis 200° C den Leistungs-MOS-FET aus, aber nur dann, wenn der erwähnte Spannungsabfall eine bestimmte Schwelle, z. B. 2 Volt, übersteigt. Bei einem sogenannten "schleichenden Kurzschluß", bei der regelmäßig die Drain-Source-Spannung des Leistungs-MOS-FET kleiner als die erwähnte Schwelle ist, ist damit ein sicherer Übertemperaturschutz des Leistungs-MOS-Fet nicht möglich. Ein "schleichender Kurzschluß" kann beispielsweise dann auftreten, wenn in der Nähe des Leistungs-MOS-FET befindliche Schaltungskomponenten stark erhitzen oder allmählich eine Kabelisolierung durchschmort.

Die Erfindung hat das Ziel, die eingangs genannte Schaltungsanordnung so weiterzubilden, daß auch bei kleinen Spannungsabfällen ein sicherer Schutz des Leistungsschalters vor Übertemperatur gewährleistet ist. Des weiteren hat die Erfindung das Ziel, eine Einchip-Lösung für eine solche Schaltungsanordnung anzugeben.

Die Schaltungsanordnung nach der Erfindung weist neben den eingangs genannten Merkmalen die im Kennzeichnender Teil des Anspruchs 1 definierten Merkmale auf.

Mit dieser Schaltungsanordnung ist es in einfacher Weise möglich, den eingeschalteten Leistungsschalter selbst dann auszuschalten, wenn die zwischen der ersten und zweiten Klemme anstehende Spannung zunächst nicht ausreicht, um die Temperatursensorschaltung auszulösen. Die Schaltungsanordnung nach der Erfindung nutzt die an dem Steueranschluß des Leistungsschalters in dessen eingeschalteten Zustand anstehende hohe Spannung und schaltet diese an die erste Klemme der Schaltungsanordnung, sobald die zwischen der ersten und zweiten Klemme anstehende Spannung unter eine vorgegebene Schwelle, z. B. 2 Volt, sinkt. Hierdurch wird das an der ersten Klemme anstehende Potential schlagartig auf etwa das Potential am Steueranschluß des Leistungsschalters erhöht, z. B. 10 Volt, so daß die Temperatursensorschaltung auslösen und den Leistungsschalter sicher abschalten kann.

Weiterbildungen der Schaltungsanordnung sind Gegenstand der auf den Anspruch 1 zurückbezogenen Ansprüche.

Die Schaltungsanordnung nach der Erfindung kann in einfacher Weise als Einchip-Lösung realisiert werden, wenn als Leistungsschalter ein n-Kanal-MOS-FET und als zwischen die erste Klemme und den Steueranschluß des Leistungs-MOS-FET zu schaltende Schalteinrichtung ein Bipolartransistor derart geschaltet ist, daß dessen Emitteranschluß mit dem Drainanschluß und der Kollektoranschluß mit dem Gateanschluß des Leistungs-MOS-FET verbunden ist.

Der Halbleiterkörper ist mit einer n⁻-dotierten Mittelzone bzw. einem n⁻-dotierten Grundkörper versehen, an dessen unteren Hauptfläche eine n⁺-dotierte Schicht anschließt. Der Halbleiterkörper weist einen ersten Bereich auf, in den auf der oberen Hauptfläche n⁺-dotierte Wannen enthaltende p-dotierte Bereiche eingebettet sind zur Bildung eines vertikalen Leistungs-MOS-FET, dessen Drainelektrode mit der n⁺-dotierten Schicht verbunden ist. Des weiteren weist der Halbleiterkörper einen zweiten Bereich für mindestens einen Bipolartransistor auf. Innerhalb des zweiten Bereichs ist auf der oberen Hauptfläche der n⁻-dotierten Mittelzone mindestens ein eine n⁺-dotierte Wanne enthaltender p-dotierter Bereich eingebettet, wobei die n⁺-dotierte Schicht in diesem zweiten Bereich mit einer Emitterelektrode, der p-dotierte Bereich mit einer Basiselektrode und die n⁺-dotierte Wanne mit einer Kollektorelektrode des Bipolartransistors verbunden ist.

Da bei einer bevorzugten Ausführungsform der Erfindung die Gate-Drain-Strecke eines Leistungs-MOS-FET durch einen Bipolartransistor kurzschließbar und der Emitteranschluß der Bipolartransistors mit der gleichen n⁺-dotierten Schicht wie die Drainelektrode des Leistungs-MOS-FET verbunden ist, können beide in einfacher Weise in einen Halbleiterkörper integriert werden, wobei die auf der n⁺-dotierten Schicht aufgebrachte Metallisierung die ohnehin notwendige elektrische Verbindung der Emitterelektrode des Bipolartransistors mit der Drainelektrode des Leistungs-MOS-FET darstellt.

Die Erfindung wird nachfolgend im Zusammenhang mit fünf Figuren näher erläutert. Es zeigen:
- Figur 1: ein Blockschaltbild einer Schaltungsanordnung nach der Erfindung,
- Figur 2: eine detaillierte Schaltungsanordnung nach der Erfindung mit einer Schalteinrichtung,
- Figur 3: die in Figur 2 schematisch dargestellte Schalteinrichtung in konkreter, schaltungstechnischer Ausführung,
- Figur 4: den Schnitt durch einen ausschnittsweise dargestellten Halbleiterkörper mit Leistungs-MOS-FET und Bipolartransistor und
- Figur 5: einen Schnitt durch einen Halbleiterkörper ähnlich zu Figur 4 mit zusätzlichem Bereich für einen lateralen MOS-FET.

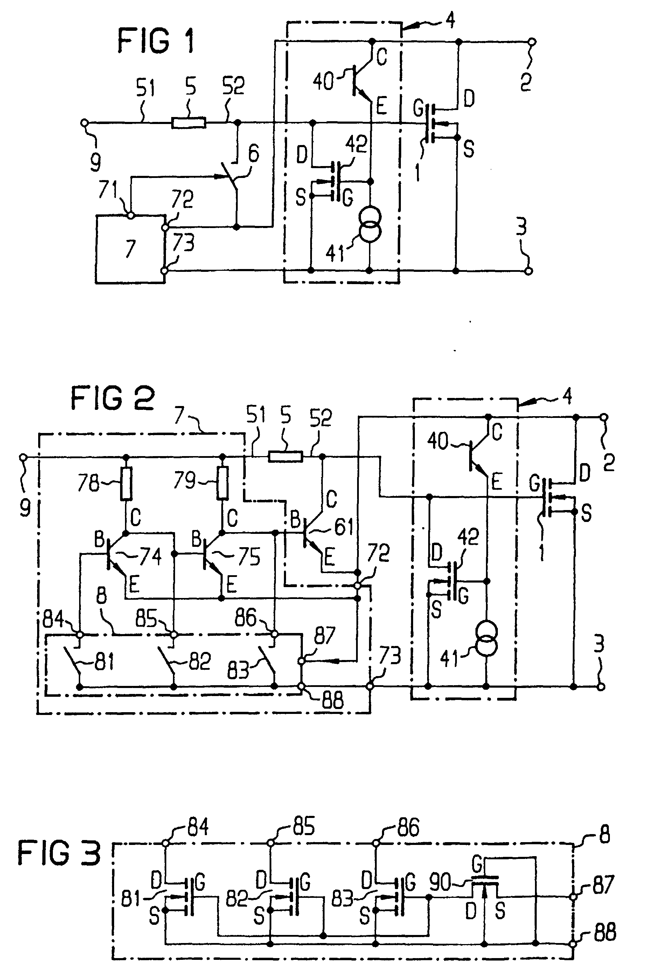

Die Schaltungsanordnung nach Figur 1 zeigt einen als Leistungsschalter 1 eingesetzten Leistungs-MOS-FET, dessen Drainanschluß D mit einer Klemme 2 und dessen Sourceanschluß S mit einer Klemme 3 verbunden ist. Der Gateanschluß G ist über einen Widerstand 5 an eine Klemme 9 geschaltet. Der Widerstand weist die beiden Anschlüsse 51, 52 auf. An dieser Klemme 9 ist ein Steuersignal zum Ein- und Ausschalten des Leistungs-MOS-FET 1 anlegbar. Zum Abschalten des Leistungs-MOS-FET 1 bei Übertemperatur ist eine an sich bekannte Temperatursensorschaltung 4 vorgesehen. Diese Temperatursensorschaltung 4 ist in der Darstellung von Figur 1, da sie als solche ohnehin bekannt ist, nur schematisch dargestellt. Die Temperatursensorschaltung 4 weist eine zwischen die Klemmen 2 und 3 geschaltete Reihenschaltung eines Temperatursensors 40 und einer Stromquelle 41 auf. Der Temperatursensor 40 ist im dargestellten Ausführungsbeispiel ein Bipolartransistor mit offenem Basisanschluß. Der Kollektoranschluß C dieses Bipolartransistors ist mit der Klemme 2 in Verbindung, während der Emitteranschluß E an die Stromquelle 41 geschaltet ist. Der Verbindungspunkt des Temperatursensors 40 und der Stromquelle 41 ist mit dem Gateanschluß G eines Depletion-MOS-FET 42 in Verbindung. Dessen Source-Anschluß S ist mit der Klemme 3 und dessen Drainanschluß D mit dem Gateanschluß G des Leistungs-MOS-FET 1 in Verbindung.

Die Funktionsweise der bis jetzt beschriebenen bekannten Schaltungsanordnung stellt sich folgendermaßen dar. Es wird hierbei angenommen, daß an der Klemme 9 ein ausreichendes positives Potential anliegt, um den Leistungs-MOS-FET 1 eingeschaltet zu halten. Solange der Temperatursensor 40 eine Temperatur unterhalb eines vorgegebenen Schwellenwertes von etwa 150 C bis 200 C erfaßt, bleibt der MOS-FET 42 aufgrund des zu geringen Stromflusses durch den Temperatursensor 40 gesperrt. Der Leistungs-MOS-FET 1 bleibt eingeschaltet. Steigt die Chiptemperatur über den erwähnten Schwellenwert, wird der MOS-FET 42 leitend, wodurch der Gateanschluß G des Leistungs-MOS-FET 1 zu dessen Sourceanschluß S kurzschließt und dadurch der Laststromfluß von der Klemme 2 zur Klemme 3 unterbrochen wird. Kühlt sich die Schaltungsanordnung wieder ab, wird der Leistungs-MOS-FET 1 entweder wieder eingeschaltet und es entsteht eine Stromoszillation durch periodisches Heizen/Abkühlen oder das System bleibt nach dem Temperaturabschalten ausgeschaltet, solange die Eingangsspannung wieder auf Nullpotential gesenkt und anschließend wieder auf positiven Wert gelegt wird. Die Temperatursensorschaltung 4 ist jedoch nur funktionsfähig, wenn die Spannung zwischen den Klemmen 2 und 3 höher als eine vorgegebene Schwelle von z. B. etwa 2 Volt ist. Darunter bleiben die bekannten Temperatursensorschaltungen 4 funktionsuntüchtig.

Die Schaltungsanordnung von Figur 1 ist deshalb um eine Schalteinrichtung 6 und eine Steuereinrichtung 7 erweitert. Die Schalteinrichtung 6 ist zwischen die erste Klemme 2 und den Steueranschluß G des Leistungs-MOS-FET 1 geschaltet. Die Steuereinrichtung 7 ist an ihrer ausgangsseitigen Klemme 71 zur Steuerung der Schalteinrichtung 6 mit dieser verbunden. Die Steuereinrichtung 7 ist des weiteren zwischen die erste Klemme 2 und die zweite Klemme 3 geschaltet. Die Klemmen 72 und 73 der Steuereinrichtung 7 sind hierfür mit der ersten Klemme 2 bzw. der zweiten Klemme 3 in Verbindung.

Die Steuereinrichtung 7 erfaßt die zwischen den Klemmen 2 und 3 liegende Spannung und hält die Schalteinrichtung 6 solange offen, solange diese Spannung einen Wert hat, bei der die Temperatursensorschaltung 4 sicher funktioniert. Sinkt diese Spannung unter die genannte Schwelle von z. B. 2 Volt, schaltet die Steuereinrichtung 7 die Schalteinrichtung 6 ein, so daß das zum Einschalten notwendige positive Gatepotential des Leistungs-MOS-FET 1 an die Klemme 2 gelegt wird. Da das zum Einschalten des Leistungs-MOS-FET notwendige Gatepotential höher ist als diejenige Spannung ist, die notwendig ist, um die Temperatursensorschaltung 4 funktionstüchtig zu machen, spricht unmittelbar nach dem Einschalten der Schalteinrichtung 6 die Temperatursensorschaltung 4 an. Bei detektierter Übertemperatur schaltet dann sofort der MOS-FET 42 ein und damit der Leistungs-MOS-FET 1 aus, selbst wenn ursprünglich die zwischen den Klemmen 2 und 3 anliegende Spannung nicht ausgereicht hätte, um die Temperatursensorschaltung 4 auszulösen.

In Figur 2 ist ein detailliertes Schaltbild der in Figur 1 vorgestellten Schaltungsanordnung gezeigt. Die bereits erläuterten Bezugszeichen werden für gleiche Teile weiter verwendet. Die in Figur 1 vorgestellte Schalteinrichtung 6 ist im Ausführungsbeispiel von Figur 2 durch einen npn-Bipolartransistor 61 realisiert, dessen Kollektoranschluß C mit dem Gateanschluß G und dessen Emitteranschluß E mit dem Drainanschluß D des Leistungs-MOS-FET 1 in Verbindung ist. Der Emitteranschluß E des Bipolartransistors 61 ist zugleich mit der Klemme 72 der Steuereinrichtung 7 in Verbindung. An diese Klemme 72 sind die Emitteranschlüsse E von zwei weiteren npn-Bipolartransistoren 74, 75 geschaltet. Die Kollektoranschlüsse C dieser beiden Bipolartransistoren 74, 75 sind jeweils über einen Widerstand 78, 79 mit der Klemme 9 und damit mit dem Anschluß 51 des Widerstandes 5 in Verbindung. Der Kollektoranschluß C des Bipolartransistors 74 ist an den Basisanschluß B des Bipolartransistors 75 geschaltet, dessen Kollektoranschluß C an den Basisanschluß B des Bipolartransistors 61 gelegt ist. Die Basisanschlüsse B der drei Bipolartransistoren 61, 74 und 75 sind jeweils mit Klemmen 86, 84 und 85 einer weiteren Schalteinrichtung 8 in Verbindung, welche drei Schalter 81, 82 und 83 aufweist, die gleichzeitig die Klemmen 84, 95 und 86 an eine Klemme 88 schalten. Die Klemme 88 ist mit der Klemme 73 in Verbindung und damit an die zweite Klemme 3 geschaltet. Die weitere Schalteinrichtung 8 verfügt über eine mit der Klemme 72 und damit der ersten Klemme 2 der Schaltungsanordnung in Verbindung stehende Klemme 87. Die Schalter 81, 82 und 83 der Schalteinrichtung 8 schalten dann aus, wenn der zwischen den Klemmen 87 und 88 der weiteren Schalteinrichtung 8 und damit der zwischen der ersten Klemme 2 und der zweiten Klemme 3 anstehende Spannungsabfall unterhalb eines bestimmten Wertes, z. B. 2 Volt, liegt.

Eine konkrete Ausführungsform der weiteren Schalteinrichtung 8 ist in Figur 3 gezeigt. Die Schalter 81, 82 und 83 sind durch n-Kanal-Enhancement-MOS-FETs realisiert, deren jeweiligen Drainanschlüsse D an eine der Klemmen 84, 85 bzw. 86 und deren Sourceanschlüsse gemeinsam an die Klemme 88 geschaltet sind. Die Gateanschlüsse G dieser MOS-FET 81, 82 und 83 sind an den Drainanschluß D eines n-Kanal Depletion-MOS-FET 90 geschaltet, dessen Sourceanschluß mit der Klemme 87 in Verbindung steht. Der Gateanschluß G und Substratanschluß dieses MOS-FET 90 ist ebenfalls mit der Klemme 88 in Verbindung.

Die Wirkungsweise der in den Figuren 2 und 3 dargestellten Schaltungsanordnung ist folgende. Es wird davon ausgegangen, daß sourceseitig an den Leistungs-MOS-FET 1 und damit an die zweite Klemme 3 eine Last, z. B. eine Glühbirne, geschaltet ist, die mit ihren zweiten Anschluß auf Bezugspotential liegt. An der ersten Klemme 2 stehen beispielsweise +15 Volt an. Um den Leistungs-MOS-FET 1 einzuschalten, wird an die klemme 9 ein ausreichend positives Potential angelegt, z. B. +20 Volt. In diesem Fall arbeitet die Temperatursensorschaltung 4 einwandfrei, da der zwischen den klemmen 2 und 3 anstehende Spannungsabfall ausreichend groß ist, um die Temperatursensorschaltung 4 funktionsfähig zu halten. In diesem Fall sind die Schalter 81, 82 und 83 der weiteren Schalteinrichtung 8 eingeschaltet. Ergebnis ist, dass der Bipolartransistor 61 ausgeschaltet bleibt.

Sinkt dagegen der zwischen den Klemmen 2 und 3 anstehende Spannungsabfall stark ab, beispielsweise auf unter 2 Volt, so werden die MOS-FET 81, 82, 83 der weiteren Schalteinrichung 8 ausgeschaltet. Der Bipolartransistor 61 wird dann über den bei steigender Temperatur leitenden Bipolartransistor 74 und den Bipolartransistor 75 eingeschaltet. Durch das Einschalten des Bipolartransistors 61 wird das am Anschluß 52 des Widerstandes 5 anstehende Potential an die erste Klemme 2 gelegt, wodurch die Temperatursensorschaltung 4 eine ausreichend hohe Spannung erhält, um zu funktionieren. Bei Übertemperatur wird der MOS-FET 42 eingeschaltet, so daß der Leistungs-MOS-FET 1 öffnet.

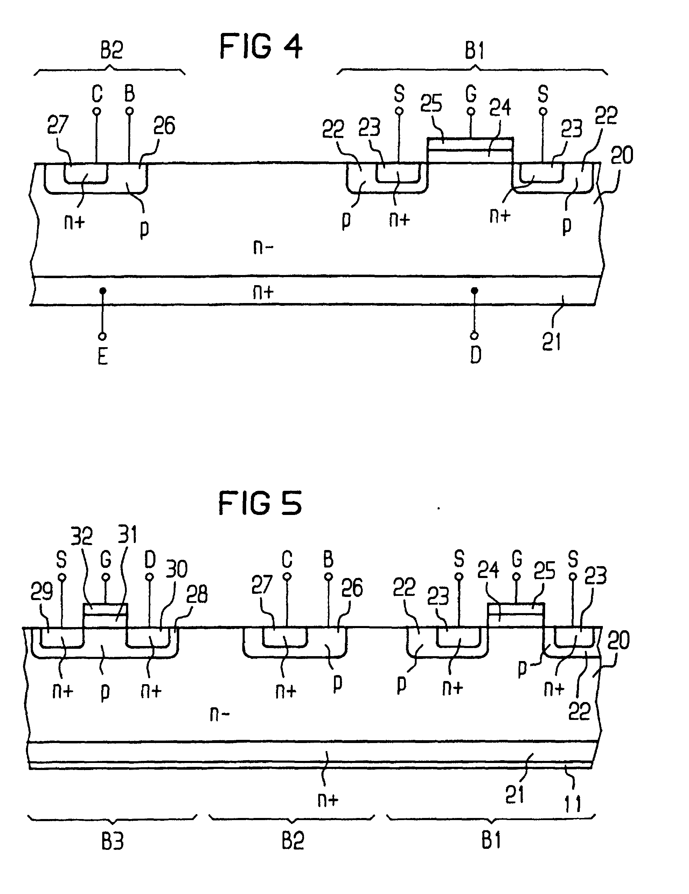

Wie aus Figur 2 deutlich hervorgeht, sind die Emitteranschlüsse E der Bipolartransistoren 61, 74 und 75 mit dem Drainanschluß D des Leistungs-MOS-FET 1 in Verbindung. Dies erlaubt die Integration der gesamten Schaltungsanordnung in einen einzigen Halbleiterkörper. Diese Integration wird im Zusammenhang mit den nachfolgenden Figuren 4 und 5 näher erläutert.

In Figur 4 ist das Schnittbild eines ausschnittsweise dargestellten Halbleiterkörpers gezeigt. Der Halbleiterkörper weist einen n--dotierten Grundkörper 20 auf, an dessen unteren Hauptfläche eine n⁺-dotierte Schicht 21 anschließt. In einem ersten Bereich B1 ist in den Grundkörper 20 ein an sich bekannter vertikaler Leistungs-MOS-FET integriert. Hierfür sind auf der oberen Hauptfläche des Grundkörpers 20 eine Vielzahl von n⁺-dotierten Wannen 23 enthaltende p-dotierte Bereiche 22 eingebettet. Die n⁺-dotierten Wannen 23 sind mit einer Sourceelektrode S in Kontakt, während auf der oberen Hauptfläche des Grundkörpers 20 zwischen den p-dotierten Bereichen 22 eine Oxidschicht 24 angeordnet ist, über welcher eine Metallschicht 25, die mit einer Gateelektrode G in Kontakt steht, sitzt. Die n⁺-dotierte Schicht 21 ist im ersten Bereich B1 mit einer Drainelektrode D in Verbindung. Bei einem solchen im Halbleiterkörper vertikal realisierten MOS-FET liegen die gesteuerten Kanäle (in Figur 4 gepunktet gezeichnet) als laterale Strukturen an der Chipoberseite, während die Drainelektrode D, wie in Figur 4 ersichtlich, auf der Chipunterseite liegt. Dazwischen befindet sich die hochohmige n--dotierte Schicht des Grundkörpers 20 zur Aufnahme einer Raumladungszone.

In einem zweiten Bereich B2 des Halbleiterkörpers ist ein vertikaler Bipolartransistor realisiert. Hierfür ist auf der oberen Hauptfläche in den Grundkörper 20 ein p-dotierter Bereich 26 eingebettet, in welchem eine n⁺-dotierte Wanne 27 sitzt. Der p-dotierte Bereich 26 ist von einer Basiselektrode B und die n⁺-dotierte Wanne 27 mit einer Kollektorelektrode C kontaktiert. Die n⁺-dotierte Schicht 21 ist im Bereich B2 des vertikalen Bipolartransistors mit einer Emitterelektrode E versehen. Bei Bedarf können mehrere, z. B. drei, wie im Zusammenhang mit der Schaltungsanordnung in Figur 2 erläutert, Bipolartransistoren im Grundkörper 20 des Halbleiterkörpers integriert sein.

Um die in Figur 2 vorgestellte Schaltungsanordnung vollständig in einen einzigen Halbleiterkörper zu integrieren, ist es ohne weiteres möglich, in den Grundkörper 20 weitere Bereiche, z. B. mit lateral angeordneten MOS-FETs, zu integrieren.

In Figur 5 ist ein solcher an sich bekannter lateraler MOSFET im dritten Bereich B3 dargestellt.

Die n⁺-dotierte Schicht 21 wird zweckmäßigerweise auf der Außenfläche mit einer Metallisierung M versehen, die die miteinander zu verbindenden Drainelektrode D des Leistungs-MOS-FET und die Emitterelektroden E der Bipolartransistoren realisiert. Die in Figur 3 vorgestellten MOS-FETs 81, 82 und 83 können in den Halbleiterkörper von Figur 5 ohne weiteres als laterale Enhancement-MOS-FETs integriert sein. Der in Figur 3 gezeigte Depletion-MOS-FET 90 wird dagegen zweckmäßigerweise vertikal realisiert. Da die in Figur 2 vorhandenen Widerstände 5, 78 und 79 ebenfalls durch Depletion-MOS-FETs ausgeführt werden können, ist die Integration der gesamten Schaltungsanordnung von Figur 2 in einen einzigen Halbleiterkörper möglich. Die in einen einzigen Halbleiterkörper integrierte Schaltungsanordnung von Figur 2 erlaubt ein sicheres Abschalten des Leistungs-MOS-FET selbst dann, wenn die an der Laststrecke des Leistungs-MOS-FET abfallende Spannung nicht ausreicht, um eine an sich bekannte Temperatursensorschaltung, die ebenfalls in den Halbleiterkörper integriert sein kann, auszulösen.

## Patentansprüche

1. Schaltungsanordnung mit einem. zwischen einer ersten Klemme (2) und einer zweiten Klemme (3) liegenden Leistungsschalter (1) und mit einer dazu parallel liegenden Temperatursensorschaltung (4), die mit einem zwischen einen Steueranschluß (G) des Leistungsschalters (1) und die zweite Klemme (3) geschalteten elektronischen Schalter (42) zum Ausschalten des Leistungsschalters bei Übertemperatur verbunden ist, **gekennzeichnet durch** die Merkmale:
a) Zwischen die erste Klemme (2) und den Steueranschluß (G) ist eine Schalteinrichtung (6) geschaltet,
b) zwischen die erste Klemme (2) und die zweite Klemme (3) ist eine Steuereinrichtung (7) geschaltet,
c) die Steuereinrichtung (7) ist ausgangsseitig mit der Schalteinrichtung (6) verbunden; und
d) wobei die Steuer einrichtung bei für die Temperatursensorschaltung (4) nicht ausreichender Spannung zwischen der ersten und der zweiten Klemme bei steigender Temperatur die Schalt einrichtung einschaltet.

2. Schaltungsanordnung nach Anspruch 1, **dadurch gekennzeichnet, daß** die Schalteinrichtung (6) einen Bipolartransistor (61) aufweist, welcher mit seiner Laststrecke zwischen den Steueranschluß (G) und die erste Klemme (2) geschaltet ist, und daß die Steuereinrichtung (7) mit dem Basisanschluß (B) des Bipolartransistors (61) verbunden ist.

3. Schaltungsanordnung nach Anspruch 1 oder 2, **dadurch gekennzeichnet, daß** die Steuereinrichtung (7) einen ersten Bipolartransistor (74) und einen zweiten Bipolartransistor (75) aufweist, welche mit ihren jeweiligen Emitteranschlüssen (E) an die erste Klemme (2) und mit ihren Kollektoranschlüssen (C) jeweils über einen Widerstand (78, 79) an einen Anschluß (51) eines weiteren Widerstandes (5) geschaltet sind, daß der andere Anschluß (52) des weiteren Widerstandes (5) mit dem Steueranschluß (G) des Leistungsschalters (1) verbunden ist, daß der Kollektoranschluß (C) des ersten Bipolartransistors (74) mit dem Basisanschluß (B) des zweiten Bipolartransistors (75) verbunden ist, daß der Kollektoranschluß (C) des zweiten Bipolartransistors (75) mit dem Steueranschluß (B) der Schalteinrichtung (6; 61) verbunden ist, und daß die Basisanschlüsse (B) des ersten und zweiten Bipolartransistors (74, 75) und der Steueranschluß (G) der Steuereinrichtung (6; 61) jeweils über Schalter (81, 82, 83) einer weiteren Schalteinrichtung (8) gleichzeitig an die zweite Klemme (3) schaltbar sind.

4. Schaltungsanordnung nach Anspruch 3 **dadurch gekennzeichnet, daß** die Schalter (81, 82, 83) der Schalteinrichtung (8) jeweils MOS-FETs sind, welche mit ihren jeweiligen Gateanschlüssen (G) über einen spannungsabhängig steuerbaren Schalter (90) an die erste Klemme (2) geschaltet sind.

5. Schaltungsanordnung nach Anspruch 4, **dadurch gekennzeichnet, daß** der Schalter (90) ein Depletion-MOS-FET ist, dessen Drainanschluß (D) an die erste Klemme (2), dessen Gateanschluß (G) an die zweite Klemme (3) und dessen Drainanschluß (D) an die Gateanschlüsse (G) der als Schalter (81, 82, 83) dienenden MOS-FETs der weiteren Schalteinrichtung (8) geschaltet ist.

6. Schaltungsanordnung nach einem der Ansprüche 1 bis 5, **dadurch gekennzeichnet, daß** der Leistungsschalter (1) ein Leistungs-MOS-FET ist, dessen Drainanschluß (D) an die erste Klemme (2) und dessen Sourceanschluß (S) an die zweite Klemme (3) geschaltet ist.

7. Schaltungsanordnung nach einem der vorangegangenen Ansprüche, bei der der Leistungsschalter (1) als vertikaler Leistungs-MOS-FET ausgebildet ist und die Schalteinrichtung (6) als Bipolartransistor ausgebildet ist, die in einem Halbleiterkörper integriert sind, der aufweist:
- einen n⁻-dotierten Grundkörper (20), an dessen unterer Hauptfläche eine n⁺-dotierte Schicht (21) anschließt,
- einen ersten Bereich (B1), in den auf der oberen Hauptfläche n⁺-dotierte Wannen (23) enthaltende p⁺-dotierte Bereiche (22) eingebettet sind zur Bildung eines vertikalen Leistungs-MOS-FET, dessen Drainelektrode (D) mit der n⁺-dotierten Schicht (21) verbunden ist, und
- einen zweiten Bereich (B2) für mindestens einen Bipolartransistor,
- wobei im zweiten Bereich (B2) auf der oberen Hauptfläche mindestens ein eine n⁺-dotierte Wanne (27) enthaltender p-dotierter Bereich (26) eingebettet ist,
und wobei die n⁺-dotierte Schicht (21) in diesem zweiten Bereich (B2) mit einer Emitterelektrode (C), der p-dotierte Bereich (26) mit einer Basiselektrode (B) und die n⁺-dotierte Wanne (27) mit einer Kollektorelektrode des Bipolartransistors verbunden ist.

8. Schaltungsanordnung nach Anspruch 7, **dadurch gekennzeichnet, dass** die n⁺-dotierte Schicht (21) des Grundkörpers ,mit einer durchgehenden, zugleich die Kollektorelektrode (c) und die Drainelektrode (D) bildenden Metallschicht (M) versehen ist.

9. Schaltungsanordnung nach Anspruch 7 oder 8, **dadurch gekennzeichnet, dass** in den Grundkörper (20) ein weiterer Bereich (B3) mit mindestens einem lateralen MOS-FET integriert ist.

## Claims

1. Circuit arrangement with a power switch (1), connected between a first terminal (2) and a second terminal (3), and with a temperature sensor circuit (4), which is connected in parallel with the said power switch and is connected to an electronic switch (42), connected between a control terminal (G) of the power switch (1) and the second terminal (3), for switching off the power switch in the event of overtemperature, **characterized by** the following features:
a) a switching device (6) is connected between the first terminal (2) and the control terminal (G),
b) a control device (7) is connected between the first terminal (2) and the second terminal (3),
c) the control device (7) is connected, on the output side, to the switching device (6), and
d) the control device switching on the switching device in the event of rising temperature in the event of a voltage between the first and second terminals which is not sufficient for the temperature sensor circuit (4).

2. Circuit arrangement according to Claim 1, **characterized in that** the switching device (6) has a bipolar transistor (61), which is connected by its load path between the control terminal (G) and the first terminal (2), and **in that** the control device (7) is connected to the base terminal (B) of the bipolar transistor (61).

3. Circuit arrangement according to Claim 1 or 2, **characterized in that** the control device (7) has a first bipolar transistor (74) and a second bipolar transistor (75), which are connected by their respective emitter terminals (E) to the first terminal (2) and by their collector terminals (C), in each case via a resistor (78, 79), to one terminal (51) of a further resistor (5), **in that** the other terminal (52) of the further resistor (5) is connected to the control terminal (G) of the power switch (1), **in that** the collector terminal (C) of the first bipolar transistor (74) is connected to the base terminal (B) of the second bipolar transistor (75), **in that** the collector terminal (C) of the second bipolar transistor (75) is connected to the control terminal (B) of the switching device (6; 61), and **in that** the base terminals (B) of the first and second bipolar transistors (74, 75) and the control terminal (G) of the control device (6; 61) can be simultaneously connected to the second terminal (3) in each case via switches (81, 82, 83) of a further switching device (8).

4. Circuit arrangement according to Claim 3, **characterized in that** the switches (81, 82, 83) of the switching device (8) are in each case MOSFETs which are connected by their respective gate terminals (G) to the first terminal (2) via a switch (90) which is controllable in a voltage-dependent manner.

5. Circuit arrangement according to Claim 4, **characterized in that** the switch (90) is a depletion-mode MOSFET whose drain terminal (D) is connected to the first terminal (2), whose gate terminal (G) is connected to the second terminal (3) and whose drain terminal (D) is connected to the gate terminals (G) of the MOSFETs of the further switching device (8) which serve as switches (81, 82, 83).

6. Circuit arrangement according to one of Claims 1 to 5, **characterized in that** the power switch (1) is a power MOSFET whose drain terminal (D) is connected to the first terminal (2) and whose source terminal (S) is connected to the second terminal (3).

7. Circuit arrangement according to one of the preceding claims, in which the power switch (1) is designed as a vertical power MOSFET and the switching device (6) is designed as a bipolar transistor, which are integrated in a semiconductor body having:
- an n⁻-doped basic body (20), whose lower main area is adjoined by an n⁺-doped layer (21),
- a first region (B1), in which are embedded p⁺-doped regions (22) containing n⁺-doped wells (23) on the upper main area, for forming a vertical power MOSFET whose drain electrode (D) is connected to the n⁺-doped layer (21), and
- a second region (B2) for at least one bipolar transistor,
- at least one p-doped region (26) containing an n⁺-doped well (27) being embedded in the second region (B2) on the upper main area,
and the n⁺-doped layer (21) in this second region (B2) being connected to an emitter electrode (C), the p-doped region (26) being connected to a base electrode (B) and the n⁺-doped well (27) being connected to a collector electrode of the bipolar transistor.

8. Circuit arrangement according to Claim 7, **characterized in that** the n⁺-doped layer (21) of the basic body is provided with a continuous metal layer (M), which simultaneously forms the collector electrode (c) and the drain electrode (B).

9. Circuit arrangement according to Claim 7 or 8, **characterized in that** a further region (B3) with at least one lateral MOSFET is integrated into the basic body (20).

## Revendications

1. Circuit avec un commutateur de puissance (1) situé entre une première borne de connexion (2) et une deuxième (3), avec en parallèle à celui-ci un circuit de capteurs de température (4) relié à une bascule électronique (42) branchée entre une borne de gâchette (G) du commutateur de puissance (1) et la deuxième borne de connexion (3) afin de désactiver le commutateur de puissance en cas d'élévation de température,
**caractérisé en ce que**
a) un dispositif de commutation (6) est branché entre la première borne de connexion (2) et la borne de gâchette (G),
b) un module de commande (7) est branché entre la première borne de connexion (2) et la deuxième borne de connexion (3),
c) le module de commande (7) est relié au dispositif de commutation (6) côté sortie, et
d) le module de commande activant le dispositif de commutation si la tension entre la première et la deuxième borne de connexion est insuffisante pour le circuit de capteurs de température (4) en cas d'élévation de température.

2. Circuit selon la revendication 1,
**caractérisé en ce que**
le dispositif de commutation (6) présente un transistor bipolaire (61) branché à sa ligne de charge entre la borne de gâchette (G) et la première borne de connexion (2), et le module de commande (7) est relié à la borne de base (B) du transistor bipolaire (61).

3. Circuit selon la revendication 1 ou 2,
**caractérisé en ce que**
le module de commande (7) présente un premier transistor bipolaire (74) et un deuxième transistor bipolaire (75) branchés, via une résistance (78, 79), avec leurs bornes d'émetteur respectives (E) à la première borne de connexion (2) et avec leurs bornes de collecteur respectives (C) à une borne (51) d'une autre résistance (5), l'autre borne (52) de l'autre résistance (5) est reliée à la borne de gâchette (G) du commutateur de puissance (1), la borne de collecteur (C) du premier transistor bipolaire (74) est reliée à la borne de base (B) du deuxième transistor bipolaire (75), la borne de collecteur (C) du deuxième transistor bipolaire (75) est reliée à la borne de gâchette (B) du dispositif de commutation (6, 61) et les bornes de base (B) du premier et du deuxième transistor bipolaire (74, 75) et la borne de gâchette (G) du module de commande (6, 61) peuvent être reliées simultanément à la deuxième borne de connexion (3) via les commutateurs (81, 82, 83) d'un autre circuit (8).

4. Circuit selon la revendication 3,
**caractérisé en ce que**
les commutateurs (81, 82, 83) du dispositif de commutation (8) sont à chaque fois des dispositifs MOS à effet de champ commutés avec leurs différentes bornes de grille (G) à la première borne de connexion (2) via un commutateur réglable (90) dépendant de la tension.

5. Circuit selon la revendication 4,
**caractérisé en ce que**
le commutateur (90) est un dispositif MOS à effet de champ de déplétion dont la borne de drain (D) est commutée à la première borne de connexion (2), dont la borne de grille (G) est connectée à la première borne de connexion (3) et dont la borne de drain (D) est commutée aux bornes de grille (G) des dispositifs MOS à effet de champ de l'autre circuit (8) servant de commutateurs (81, 82, 83).

6. Circuit selon l'une des revendications 1 à 5,
**caractérisé en ce que**
le commutateur de puissance (1) est un dispositif MOS de puissance à effet de champ dont la borne de drain (D) est commutée à la première borne de connexion (2) et dont la borne de source (S) est commutée à la deuxième borne de connexion (3).

7. Circuit selon l'une des revendications précédentes,
dans lequel le commutateur de puissance (1) est construit sous forme de dispositif MOS vertical de puissance à effet de champ et le dispositif de commutation (6) sous forme de transistor bipolaire, lesquels sont intégrés dans un corps semi-conducteur, qui présente :
- un corps de base (20) dopé n⁻ à la surface principale inférieure duquel une couche dopée n⁺ (21) est raccordée,
- un premier secteur (B1) dans lequel des secteurs dopés p+ (22) contenant des cuves dopées n⁺ (23) sont encastrés sur la surface principale supérieure pour former un dispositif MOS vertical de puissance à effet de champ dont l'électrode de drain (D) est reliée à la couche (21) dopée n⁺,
- un deuxième secteur (B2) pour au moins un transistor bipolaire,
- au moins un secteur (26) dopé p contenant une cuve n⁺ (27) étant encastré sur la surface principale supérieure dans le deuxième secteur (B2), et
- la couche dopée n⁺ (21) étant reliée à une électrode d'émetteur (C) dans ce deuxième secteur (B2), le secteur dopé p (26) étant relié à une électrode de base (B) et la cuve dopée n⁺ (27) étant reliée à une électrode de collecteur du transistor bipolaire.

8. Circuit selon la revendication 7,
**caractérisé en ce que**
la couche dopée n+ (21) du corps de base est dotée d'une couche métallique (M) continue formant à la fois l'électrode de collecteur (c) et l'électrode de drain (D).

9. Circuit selon la revendication 7 ou 8,
**caractérisé en ce qu'**
un autre secteur (B3) avec au moins un dispositif MOS latéral à effet de champ est intégré dans le corps de base (20).
